Europäisches Patentamt

European Patent Office

Office européen des brevets

(19)

(11) Veröffentlichungsnummer: **0 133 698**
**B1**

(12) **EUROPÄISCHE PATENTSCHRIFT**

(45) Veröffentlichungstag der Patentschrift: **13.06.90**

(51) Int. Cl.⁵: **H 01 L 31/02, H 01 L 31/06**

(21) Anmeldenummer: **84109334.7**

(22) Anmeldetag: **07.08.84**

(54) **Photovoltaische Zelle sowie Verfahren zum Herstellen dieser.**

(30) Priorität: **10.08.83 DE 3328869**

(43) Veröffentlichungstag der Anmeldung:
**06.03.85 Patentblatt 85/10**

(45) Bekanntmachung des Hinweises auf die
Patenterteilung:
**13.06.90 Patentblatt 90/24**

(84) Benannte Vertragsstaaten:
**DE FR IT**

(56) Entgegenhaltungen:
DE-A-2 732 933
GB-A-1 395 200
US-A-4 254 546
US-A-4 267 398
US-A-4 338 482

Patent Abstracts of Japan, Vol.5, No.153(E-76)(825) 26.Sept 1981 &JP-A-5685875

(73) Patentinhaber: **Nukem GmbH**
**Rodenbacher Chaussee 6 Postfach 11 00 80**
**D-6450 Hanau 11 (DE)**

(72) Erfinder: **Hewig, Gert, Dr.**
**Somborner Strasse 6**
**D-8755 Alzenau (DE)**
Erfinder: **Schurich, Bernd, Dr. Dipl.-Phys.**
**Ulmenweg 6**
**D-6454 Bruchköbel (DE)**
Erfinder: **Wörner, Jörg, Dr. Dipl.-Chem.**
**Philipp-Reis-Strasse 16**
**D-6451 Grosskrotzenburg (DE)**
Erfinder: **Schock, Hans-Werner, Dipl.-Ing.**
**Am Wallgraben 18**
**D-7000 Stuttgart 80 (DE)**

(74) Vertreter: **Stoffregen, Hans-Herbert, Dr. Dipl.-Phys. et al**
**Patentanwälte Strasse & Stoffregen Salzstrasse**
**11a Postfach 2144**
**D-6450 Hanau/Main 1 (DE)**

EP 0 133 698 B1

EP 0 133 698 B1

**Beschreibung**

Die Erfindung bezieht sich auf photovoltaische Zellen insbesondere Dünnschicht-Solarzellen nach dem Oberbegriff des Anspruchs 1 sowie auf ein Verfahren zum Herstellen entsprechender photovoltaischer Zellen.

Photovoltaische Zellen oder auch Solarzellen genannt zeigen eine diodenartige Struktur und können aus einkristallinen oder amorphen Substanzen aufgebaut sein. Beispielhaft sie auf die US—A—40 64 521 oder die DE—A—27 32 933 verwiesen, in denen Dünnschicht-Solarzellen beschrieben werden, die aus amorphem Silizium oder Cadmiumsulfid-Kupfersulfid bestehen.

Um einen hohen Wirkungsgrad einer Solarzelle zu erzielen, ist es unter anderem erforderlich, daß der frontseitige, also lichtquellenseitige elektrische Kontakt eine hohe Strahlungsdurchlässigkeit gewährleistet, daß also die Solarzelle so wenig wie möglich abgeschattet wird. Dabei ist es bekannt, ein metallisches Gitter auf einem Träger aus Glas herzustellen und mittels eines Heißsiegelklebers mit der Solarzelle zu verpressen oder das Gitter durch Aufdampfen eines Metalls im Hochvakuum durch eine geeignete Maske herzustellen. Feine Gitter mit einem Stegabstand im Bereich von 1 mm werden für Solarzellen benötigt, wenn die frontseitige Halbleiterschicht einen Flächenwiderstand im Bereich von $K\Omega$ aufweist, wie er zum Beispiel für $Cu_2S/CdS$-Dünnschicht-Solarzellen typisch ist. Ferner müssen die Gitter bei Verwendung einer einzigen Kontaktkomponente eine Mindeststärke aufweisen, um die Stromableitung im gewünschten Umfang sicherzustellen. Will man also hinsichtlich der Herstellungs- und Materialkosten günstig fahren, muß man hinsichtlich der Strahlungsdurchlässigkeit Einbußen hinnehmen.

Das Einbrennen der Kontakte ist bei terrestrischen Solarzellen ebenfalls nicht möglich, da man Herstellungstemperaturn <400°C einhalten sollte. Daher scheiden siebgedruckte Einbrennpräparate, wie sie bei c-Si-Solarzellen verwandt werden, aus. Auch bei a-Si-Solarzellen müssen Herstellungstemperaturen <400°C eingehalten werden, da sonst der Wasserstoff ausdiffundiert.

Aus der US—A—4,338,482 ist eine Solarzelle bekannt, deren frontseitiger elektrischer Kontakt drei Schichten umfaßt, deren physikalische Eigenschaften im wesentlichen auf eine Verminderung der Lichtreflexion ausgerichtet sind. Die Struktur der unteren dem Halbleitermaterial benachbarten Schichten ist zur Vermeidung teurer und zerbrechlicher Gitter mit feinen metallischen Streifen flächendeckend ausgebildet.

Es ist daher Aufgabe der vorliegenden Erfindung, photovoltaische Zellen der eingangs genannten Art so weiterzubilden, daß insbesondere die frontseitige Kontaktierung einfach und kostengünstig erfolgt, wobei gleichzeitig bei guter Stromableitung eine Verbesserung der Strahlungsdurchlässigkeit gegeben sein soll, daß also die Abschattung der aktiven Schichten durch den zweiten elektrischen Kontakt gering gehalten wird.

Die Aufgabe wird durch eine photovoltaische Zelle nach dem Kennzeichen des Anspruchs 1 gelöst.

Die einzelnen Schichten, insbesondere die Stromsammler- (SS-) und Stromableiter- (SA) Schicht, können jeweils für sich streifen- bzw. linienförmig angeordnet werden, wobei sich jedoch in Draufsicht eine Gitterstruktur ergeben sollte. Dabei kann die Breite der Linien im Vergleich zu den Gitterkontakten einheitlichen Materials kleiner gewählt werden, so daß sich eine geringere Abschattung des aktiven Materials der Solarzelle ergibt.

Um die Stromsammler- und Stromableiter-Schichten gut zu fixieren, können diese nach einer Ausgestaltung der Erfindung in einer transparenten Fixierschicht zumindest teilweise eingebettet oder von dieser verklebt sein. Diese vorzugsweise nichtleitende transparente Schicht kann dabei sogar als Maske für das Aufbringen der einzelnen Schichten zur Bildung des frontseitigen elektrischen Kontakts herangezogen werden. Die transparente Schicht kann zum Beispiel im Siebdruckverfahren derart aufgetragen werden, daß sich eine mehr oder weniger regelmäßige Anordnung von Ausnehmungen ergibt, in die dann die den Frontkontakt bildenden Schichten selektiv zum Beispiel chemisch, physikalisch oder galvanisch eingebracht werden können.

Bevorzugterweise weisen nur die SS-Schicht und die SA-Schicht im aufgebrachten Zustand eine Gitterstruktur auf, wohingengen die KV-Schicht nur unter den Bereichen der Stromsammlerschicht auf die zweite Halbleiterschicht aufgebracht ist. Kontaktvermittler kann auch als Leitkleber auf das Gitter aufgebracht werden, um damit SS und SA mit dem Halbleiter fest zu verbinden. Eine ganzflächige KV-Schicht, die selbstverständlich transparent sein muß, kann zum Beispiel durch Sputtern, Abscheidungen aus chemischen Lösungen oder Drucken von ITO, $SnO_x$ oder organischen Leitern wie zum Beispiel Polyphenylacetylene, Polyphenylene, Polythiophene, Polypyrrole, Polyphenylensulfide und Tetrathiofulvalen tetracyanoquinidomethan bestehen.

Um ein Zerstören des frontseitigen elektrisch leitenden Kontakts durch zum Beispiel thermische Schwankungen oder ähnliches auszuschließen, findet eine mechanische Entkopplung zwischen dem Deckglas und dem frontseitigen elektrischen Kontakt statt. Diese zweite transparente aus nichtleitendem Material bestehende Schicht kann aus Kunststoff (Polymerschicht) bestehen.

Dabei dürften Materialien wie Silikone und Polyvinylbutyral mit geeigneten Weichmachern wie Epoxydharze besonders geeignet sein. Auf diese Entkopplungsschicht wird sodann das rückseitig einen Haftvermittler aufweisende Deckglas aufgebracht, das gegebenenfalls durch eine Kunststoffschicht ersetzt sein kann, um anschließend die Zelle zu verkapseln. Auch können die Fixierschicht und die Entkopplungsschicht aus dem gleichen Material bestehen.

Als Materialien für die Kontaktvermittlerschicht sind neben ITO, $SnO_x$ oder organischen Leitern

selektiv aufgetragenes Gold, Palladium oder Kohlenstoff-Pasten oder Kohlenstoff-Kleber. Letzere sind besonders hervorzuheben.

Die Stromsammlerschicht besteht vorzugsweise aus Silberleitpaste. Die sich anschließende Stromableiterschicht besteht vorzugsweise aus Kupfer oder Silberleitpaste.

Selbstverständlich kann nach einer weiteren Ausführungsform die Stromsammlerschicht und die Stromableiterschicht als Einheit und in Stegform ausgebildet sein.

Dabei kann zusätzlich zumindest eine der oberen lichtquellenseitigen Schichten des zweiten elektrischen Kontakts von einer Fixierschicht fixiert sein. Die Fixier- und Entkopplungsschichten müssen selbstverständlich transparent ausgebildet sein.

In Ausgestaltung wird die vorzugsweise nach Art des Siebdruckverfahrens aufgebrachte Fixierschichts als Freiräume aufweisende Maskierungsschicht ausgebildet, in deren Freiräume zumindest einige der den Frontkontakt bildenden Schichten eingebracht werden.

Die Fixierschicht, in die zumindest teilweise der zweite elektrisch leitende Kontakt zur mechanischen Fixierung eingebettet ist, kann ein aktivierbarer Kleber wie zum Beispiel Epoxydharze sein, der zum Beispiel mittels Temperatur, Druck, UV-Strahlen oder IR-Strahlen ausgehärtet wird. Fixierschicht und Entkopplungsschicht können dabei auch aus demselben Grundmaterial, wie zum Beispiel Polyvinylbutyral bestehen, wenn der Entkopplungsschicht beispielsweise mehr Weichmacher, wie zum Beispiel Epoxidharz, beigemischt wird als der Fixierschicht.

Bevorzugterweise wird die Kontaktvermittler-Schicht aus Kohlenstoff-Pasten oder Kohlenstoff-Klebern selektiv durch zum Beispiel Drucken mit einem Sieb oder einem Tampon aufgebracht, wobei die Schicht anschließend zu ihrer Formierung bei einer Temperatur T mit T≤200°C, vorzugsweise 140°C≤T≤160°C, thermisch behandelt wird.

Die Verwendung von Ruß-/Graphit-Pasten als KV-Schicht hat im Vergleich zu z.B. galvanisch aufgetragenen Schichten den wesentlichen Vorteil, daß in der zweiten Halbleiter-Schicht vorhandene Pin-Holes nicht notwendigerweise ausgefüllt werden müssen. Dadurch wird die Gefahr der Bildung von niederohmigen Nebenschlüssen reduziert.

Durch die erfindungsgemäße Ausgestaltung von photovoltaischen Zellen bzw. deren Herstellung ist die Möglichkeit gegeben, daß die den frontseitigen Kontakt bildenden Schichten flächenmäßig im Vergleich zu der aktiven Zone der Halbleiterschicht so klein gewählt werden können, daß sich eine geringe Abschattung, die sich in einer Erhöhung des Wirkungsgrades der Solarzelle äußere, ergibt. Ferner ist durch das Einbetten bzw. Verkleben des frontseitigen Kontakts und durch die mechanische Entkopplung von den angrenzenden Bereichen der Solarzelle sichergestellt, daß im Vergleich zu bekannten Solarzellen thermische Beanspruchungen in geringerem Umfang zu Zerstörungen des frontseitigen Kontakts und damit zur Unwirksamkeit der Solarzelle führen.

Erfindungsgemäß erfolgt auch ein additives Auftragen der Schichten an den Ort, also auf der zweiten Halbleiterschicht, wo der zweite elektrische Kontakt benötigt wird. Hieren ist allein kostenmäßig ein nicht zu vernachlässigender Vorteil gegenüber dem substraktiven Verfahren zu sehen.

Weitere Einzelheiten, Vorteile und Merkmale der Erfindung ergeben sich aus den Ansprüchen und dem in der Zeichnung dargestellten Ausführungsbeispiel.

Es zeigen:

Fig. 1 eine Prinzipdarstellung des Aufbaus einer erfindungsgemäßen photovoltaischen Zelle (nicht maßstabsgetreu),

Fig. 2 eine nicht erfindungsgemäße Solarzelle in Draufsicht und

Fig. 3 eine Ausführungsform einer Solarzelle gemäß der Erfindung in Draufsicht.

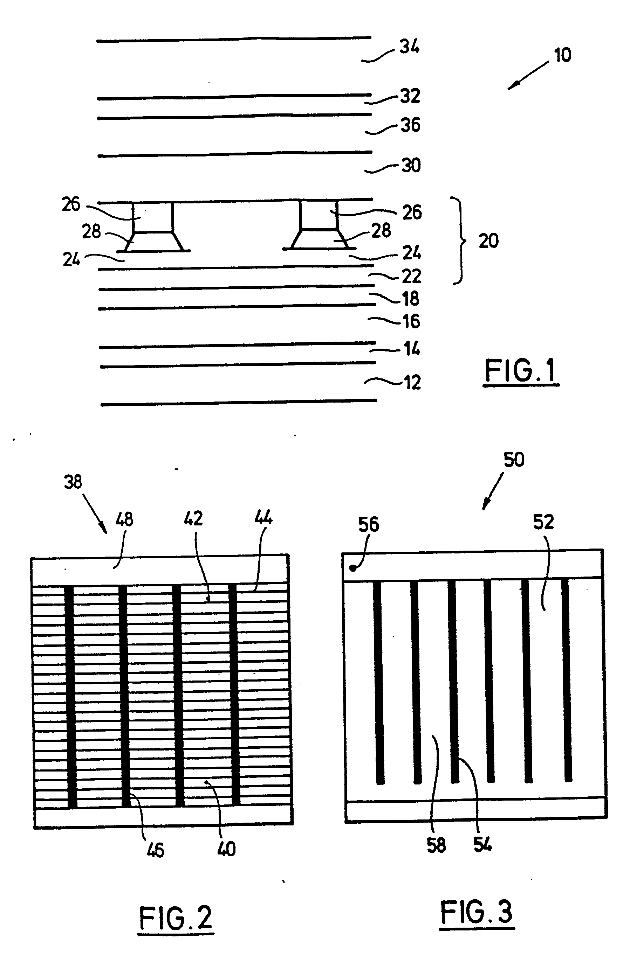

In Fig. 1 ist der prinzipielle Aufbau einer Solarzelle 10 dargestellt, anhand derer die erfindungswesentlichen Merkmale verdeutlicht werden sollen. Auf einer Grundplatte 12, die vorzugsweise aus einem Substratglas besteht, wird ein erster elektrisch leitender Kontakt 14 aufgebracht, der zum Beispiel aus einer Silberschicht oder einer einfachen transparenten Schicht bestehen kann, die durch Aufdampfen auf das Substratglas 12 aufgetragen wird. Dabei kann selbstverständlich zwischen dem Substratglas 12 und dem Kontakt 14 eine Haftvermittlungsschicht angeordnet sein.

Im Falle, daß es sich bei Solarzelle 10 um eine Cadmiumsulfid-Kupfersulfid-Solarzelle handelt, wird auf den ersten elektrisch leitenden Kontakt 14 eine Schicht 16 aus Cadmiumsulfid der Stärke von ca. 30 um aufgedampft. Auf diese erste Halbleiterschicht 16, die gegebenenfalls zur Verringerung von Reflexionen und zum Herausätzen von Korngrenzen mit Hilfe einer wässrigen Salzsäure aufgerauht werden kann, wird eine Kupfersulfidschicht 18 aufgetragen. Dies erfolgt zum Beispiel durch eine chemische Reaktion mittels Eintauchens in eine einwertige Kupfer-Ionenlösung. Diese Kupfersulfidschicht 18 als zweite (frontseitige) Halbleiterschicht weist dann eine Dicke von ungefähr 0,2 μm auf. Auf die Halbleitschicht 18 wird nun erfindungsgemäß ein zweiter elektrisch leitender Kontakt 20 aufgebracht, der sich aus einer Kontaktvermittlerschicht (KV-Schicht) 22, einer Stromsammlerschicht (SS-Schicht) 24 und einer Stromableiterschicht (SA-Schicht) 26 zusammensetzt, die -wie die Prinzipdarstellung verdeutlichen sollversetzt zueinander angeordnet sind. (Im Ausführungsbeispiel ist zwischen der SA-Schicht 26 und der SS-Schicht 24 noch ein Kontaktvermittler 28 in Form zum Beispiel einem Lot vorgesehen).

Im Ausführungsbeispiel ist die KV-Schicht 22 ganzflächig ausgebildet, sie wird erfindungsgemäß selektiv, also nicht ganzflächig aufgetragen. Die SS-Schicht 24 und die SA-Schicht 26 zeigen jeweils eine Streifen- oder Linienform wie die Fig.

2 und 3 näher verdeutlichen, wobei sich die Streifen oder Linien vorzugsweise kreuzen, so daß sich in Draufsicht ein gitterförmiger zweiter elektrischer Kontakt 20 ergibt, da die KV-Schicht 22 transparent ist.

Die KV-Schicht 22, die eine Stärke von 2 bis 3 µm haben kann, wird im Falle einer ganzflächen Ausbildung zum Beispiel durch Sputtern, Abscheiden aus einer chemischen Lösung Drukken von ITO, $SnO_x$ oder organischen Leitern wie zum Beispiel Polyphenylacetylene, Polyphenylene, Polythiophene, Polypyrrole, Polyphenylensulfide und Tetrathiofulvalen tetracyanoquinidomethan aufgetragen. Alternativ kann die KV-Schicht 22 selektiv durch Drucken mit Steb oder Tampon von Gold, Palladium oder Kohlenstoff-Pasten oder Kohlenstoff-Kleber auf die zweite Halbleiterschicht 18 aufgetragen werden. Herstellungsmäßig kann auch auf die zweite Halbleiterschicht 18 eine durchgehende, Ausnehmungen aufweisende Maskierungsschicht aufgetragen werden, wobei dann in die vorhandenen Freiräume das Kontaktvermittler-Material abgeschieden wird, Gegebenenfalls kann die Maskierungsschicht selbst die KV-Schicht bilden. Für den Fall, daß jedoch getrennt eine KV-Schicht eingebracht werden soll, ist als geeignetes Material gleichfalls Gold, Palladium oder Kohlenstoff-Paste oder Kohlenstoff-Kleber zu bezeichnen, die zum Beispiel galvanisch oder elektrophoretisch abgeschieden werden. Die Kontaktvermittlerschicht 22 stellt -unabhängig von ihrer Geometrie- eine gute Ohm'sche Ankopplung zu der zweiten Halbleiterschicht 18 dar.

Auf die KV-Schicht 22 wird sodann die SS-Schicht aufgebracht, die bevorzugterweise aus parallel zueinander verlaufenden Streifen oder Linien besteht. Dabei kann die Breite der Streifen 30—150 µm bei einer Höhe von in etwa 10—35 µm betragen. Die SS-Schicht 24 kann durch Drukken von Pasten oder durch bekannte galvanische, chemische oder physikalische Methoden auf die KV-Schicht 22 aufgebracht werden. Als Material für die Stromsammlerschicht 24 eignen sich insbesondere Nickel, Kupfer, Lot wie zum Beispiel Indium, wobei Nickel dann Verwendung findet, wenn die KV-Schicht 22 aus Gold besteht, um so eine Permeation von Au zu unterbinden.

An die KV-Schicht 24 schließt sich dann -gegebenenfalls über einen Kontaktvermittler 28 in Form einer Paste- die Stromableiterschicht 26 an, um über diese von der Stromsammlerschicht 24 gesammelte Ladungsträger an zum Beispiel eine nicht dargestellte Leiterbahn, die zum Verschalten mehrerer Solarzellen bestimmt ist, oder an einen Verbraucher abzuleiten. Die SA-Schicht 26, die gleichfalls eine Höhe von 10 µm—35 µm aufweisen kann, besteht vorzugsweise gleichfalls aus parallel oder in etwa parallel zueinander laufenden Streifen einer Breite von 100—500 µm. Die Stromableiterschicht 26, die vorzugsweise aus Kupfer besteht, kann dabei galvanisch oder elektrophoretisch abgeschieden werden. Ferner weisen die Streifen der SA-Schicht 26 eine andere Orientierung als die der SA-Schicht 24 auf. Vorzugsweise ergibt sich in Draufsicht eine gitterförmige Struktur.

Auf den im wesentlichen durch die Kontaktvermittlerschicht 22, der Stromsammlerschicht 24 und der Stromableiterschicht 26 gebildeten frontseitigen Kontakt 20 schließt sich eine weitere Schicht 30 an, deren Aufgabe es ist, den zweiten elektrisch leitenden Kontakt 20 zu fixieren. Ist im Ausführungsbeispiel die Fixierschicht 30, die aus transparentem Material besteht und vorzugsweise nichtleitend ist, auf den elektrischen Kontakt 20 aufgetragen. Dabei dürfte jedoch bevorzugt der elektrische Kontakt 20, soweit dieser aus streifenförmigen Schichten besteht, in die Schicht 30 eingebettet sein. Die Fixierschicht 30 kann aus chemisch oder physikalisch zum Beispiel durch UV-Bestrahlung, Temperaten oder Druck härtenden Polymeren bestehen und wird vorzugsweise in Siebdrucktechnik aufgebracht.

Auf die Fixierschicht 30 kann sodann gegebenenfalls mit einer Haftvermittler 32 versehen Abdeckplatte 34 aufgebracht werden, um so die fertige Solarzelle 10 zur Verfügung zu stellen. Um jedoch sicherzustellen, daß thermische oder mechanische Belastung zu einer Zerstörung des frontseitigen Kontakts 20 nicht führt, findet in erfinderischer Ausgestaltung eine mechanische Entkopplung zwischen dem Abdeckglass 34 und dem von der Schicht 30 teilweise eingebetteten gitterförmigen Kontakt 20 durch Anordnen einer weiteren vorzugsweise aus Kunststoff wie Silikonkautschuk oder PVB bestehenden Schicht 36 statt, die durch Druck- oder Gießtechnik aufgebracht werden kann. Diese Entkopplungsschicht 36 dient dazu, um insbesondere Dehnungsunterschiede zwischen dem frontseitigen Kontakt 20 und den angrenzenden Schichten aufzunehmen, so daß eine mechanische Zerstörung nicht erfolgen kann.

Der zuvor wiedergegebene Aufbau der Solarzelle 10 kann auch bei Tandemsystemen beibehalten werden, wobei das Substratglas der auf das Abdeckglas 34 aufzusetzende zweite Zelle eine Folie sein kann und der erste elektrisch leitende Kontakt transparent ist, um auf diese dann eine Solarzelle des zuvor beschriebenen Aufbaus anzuordnen.

In Fig. 2 ist in Draufsicht eine Solarzelle 38 dargestellt, aus der die gitterförmige Struktur eines frontseitigen Kontaktes 40 deutlich hervorgeht. Der frontseitige Kontakt 40 setzt sich dabei im wesentlichen aus drei Schichten 42, 44 und 46 zusammen. Die Schicht 42 ist transparent und ganzflächig ausgebildet und stellt die KV-Schicht dar. Auf die KV-Schicht ist dann die SS-Schicht 44 in Form von zueinander beabstandeten und im wesentlichen parallel verlaufenden Linien durch zum Beispiel Drucken oder galvanische, chemische oder physikalische Methoden aufgebracht. Der Abstand zwischen den einzelnen Streifen bzw. Linien, die eine Breite von 30—150 µm aufweisen, ist vorzugsweise 700 µm bis 1000 µm. Auf die SS-Schicht 44 ist sodann die ebenfalls streifenförmig ausgebildete SA-Schicht 46 aufgebracht, die aus Kupferbahnen bestehen kann. Die Breite dieser Kupferbahnen kann sich dabei auf 100 bis 500µm belaufen, wobei der Abstand zwischen den einzelnen Bahnen vorzugsweise 1—10 mm beträgt. Die Kupferbahnen 46 können sodann mit einer am Rand der Solarzelle 38 angedeuteten Leiterbahn 48 verbunden sein, die ihrerseits mit Leiterbahnen weiterer Solarzellen verbunden oder aber an einen Verbraucher angeschlossen ist. Im übrigen ist der Aufbau der Solarzelle 38 im wesentlichen der gleiche wie der in Fig. 1 beschriebene, daß also die SS-Schicht 44 und die SA-Schicht 46 durch eine transparente Schicht lagefixiert sind und durch eine unterhalb des Abdeckglases angeordnete Entkopplungsschicht geschützt sind.

Die in Fig. 3 in Draufsicht dargestellte Solarzelle 50 weist hinsichtlich seines frontseitigen elektrisch leitenden Kontakts 52 keine Gitter struktur auf. Dies liegt darin begründet, daß die SS-Schicht und die SA-Schicht als Einheit in Form von vorzugsweise parallel zueinander verlaufenden Bahnen 54 ausgebildet sind, die ihrerseits in einer Leiterbahn 56 münden. Die Linien bzw. Stege 54 haben dabei bei zum Beispiel einer Solarzelle der Größe 10×10 cm² den Abstand von 700 µm bis 1000 µm, wobei der Querschnitt jedes einzelnen Steges ungefähr 35×100 µm² beträgt.

Zu den spezifischen Widerständen der einzelnen Schichten ist zu bemerken, daß diese in der Größenordnung für $\rho_{KV} \leqslant 1$ Ohm cm, $\rho_{SS} \leqslant 10^{-2}$ Ohm cm und $\rho_{SA} \leqslant 10^{-4}$ Ohm cm liegen.

Sind die SA-Schicht und die SS-Schichten -wie in Fig. 3 dargestelltals Einheit in Form von Streifen bzw. Linien ausgebildet, so its $\rho \leqslant 10^{-4}$ Ohm cm.

Aufgrund der erfindungsgemäßen Lehre, zeigt sich der Vorteil, daß die Gesamtfläche des elektrischen Kontaktes im Vergleich zu Kontakten einheitlichen Materials in Bezug auf die aktive Fläche der Solarzelle kleiner gewählt werden kann, so daß sich ohne Einbußen hinsichtlich der Stromableitung eine geringere Abschattung und damit ein höherer Wirkungsgrad ergibt. Der Frontkontakt kann demzufolge als transparent bezeichnet werden.

**Patentansprüche**

1. Photovoltaische Zelle, insbesondere Dünnschichtsolarzelle (10, 50) umfassend einen auf einem Träger (12) aufgebrachten (ersten) elektrischen Kontakt (14), auf dem eine erste (rückseitige) und eine zweite (frontseitige) Halbleiterschicht (16, 18) unterschiedlichen Leitertyps angeordnet sind, einen mit der zweiten Halbleiterschicht (18) verbundenen zweiten (frontseitigen) drei Schichten (22, 24; 26) umfassenden elektrischen Kontakt sowie gegebenenfalls ein die Zelle abdeckendes Deckelelement (34) wie Deckglas, dadurch gekennzeichnet, daß die drei Schichten (22; 24; 26) des frontseitigen Kontaktes (20, 52) sich zusammensetzen aus einer eine Ohm'sche Ankopplung zur zweiten Halbleiterschicht (18) bildenden Kontaktvermittlerschicht (22), die aus ITO, SnO$_x$, CdSnO$_x$, einem organischen Leiter, Gold, Palladium, Kohlenstoff-Paste oder Kohlenstoffkeber besteht und einen spezifischen Widerstand $\rho \leqslant 1$ Ohm cm aufweist, einer Ladungsträger der zweiten Halbleiterschicht sammelnden Stromsammlerschicht (24) mit einem spezifischen Widerstand $\rho \leqslant 10^{-2}$ Ohm·cm und einer Stromableiterschicht (26) mit einem spezifischen Widerstand $\rho \leqslant 10^{-4}$ Ohm cm, wobei jede der drei Schichten nur bereichweise die zweite Halbleiterschicht (18) abdeckt und zumindest zwei Schichter in Draufsicht nicht fluchtend angeordnet sind.

2. Zelle nach Anspruch 1, dadurch gekennzeichnet, daß die Stromsammlerschicht (24) und die Stromableiterschicht (26) insbesondere zu deren Fixierung zumindest teilweise in einer Schicht (30) eingebettet oder mit dieser Schicht (30) verklebt sind.

3. Zelle nach Anspruch 2, dadurch gekennzeichnet, daß die Fixierschicht (30) eine Maske für das Aufbringen der den frontseitigen elektrischen Kontakt bildenden Schichten oder einiger dieser ist.

4. Zelle nach Anspruch 1, dadurch gekennzeichnet, daß die Stromsammlerschicht (24) und die Stromableiterschicht (26) als Einheit selektiv aufgebracht sind und vorzugsweise aus sich kreuzenden Linien bzw. Streifen bestehen.

5. Zelle nach Anspruch 1, dadurch gekennzeichnet, daß die Kontaktvermittlerschicht (22) zu ihrer Formierung bei einer Temperatur T mit T<200°C thermisch behandelt ist.

6. Zelle nach Anspruch 1, dadurch gekennzeichnet, daß die ohm'sche Ankopplung und die Leitfähigkeit der aus Kohlenstoff-Kleber oder Kohlenstoff-Paste bestehen Kontaktvermittlerschicht (22, 54) durch Graphit- und Ruß-Teilchen bestimmt ist.

7. Zelle nach Anspruch 1, dadurch gekennzeichnet, daß die Stromsammlerschicht (24, 54) aus einer Silberleitpaste und die Stromableiterschicht (26, 54) aus Kupfer oder Silberleitpaste bestehen.

8. Zelle nach Anspruch 1, dadurch gekennzeichnet, daß der frontseitige elektrische Kontakt (20, 52) von einer Fixierschicht aufgenommen ist, auf die eine eine mechanische Entkopplung bewirkende Entkopplungssicht (36) aufgetragen ist, wobei die Fixierschicht und die Entkopplungsschicht aus dem selben Grundmaterial wie zum Beispiel Polyvinylbutyral mit unterschiedlichen Anteilen von Weichmachern bestehen.

9. Verfahren zum Herstellen von photovoltaischen Zellen nach einem der Ansprüche 1 bis 8, umfassend im wesentlichen die Verfahrensschritte,

a) Aufbringen eines ersten elektrisch leitenden Kontakts auf einen Träger,

b) Aufbringen einer ersten und anschließend einer zweiten frontseitigen Halbleiterschicht unterschiedlichen Leitertyps auf den ersten elektrich leitenden Kontakt,

c) Aufbringen eines zweiten (frontseitigen) elektrisch leitenden Kontakts auf die zweite Halbleiterschicht,

d) Abdecken des zweiten elektrisch leitenden Kontakts mit einem Deckelement,

e) Verkapseln der photovoltaischen Zelle,

wobei das Aufbringen des zweiten elektrisch leitenden Kontakts durch sukzessives Auftragen der verschiedenen elektrisch leitenden Schichten erfolgt, von denen jede die zweite Halbleiterschicht nur bereichsweise abdeckt und von denen mindestens zwei nicht fluchtend zueinander ausgerichtet werden, und wobei auf den zweiten elektrisch leitenden Kontakt eine das Deckelement von diesem mechanisch entkoppelnde Schicht aufgetragen wird.

10. Verfahren nach anspruch 9, dadurch gekennzeichnet, daß zumindest einer der oberen lichtquellenseitigen Schichten des zweiten elektrisch leitenden Kontakts von einer Fixiersvhicht fixiert wird.

11. Verfahren nach Anspruch 10, dadurch gekennzeichnet, daß die vorzugsweise nach Art des Siebdruckverfahrens aufgebrachte Fixierschicht als Freiräume aufweisende Maskierungsschicht ausgebildet wird, in deren Freiräume zumindest einige der den zweiten elektrisch leitenden Kontakt bildenden Schichten eingebracht werden.

12. Verfahren nach Anspruch 9, dadurch gekennzeichnet, daß die Kontaktvermittler-Schicht aus Kohlenstoff-Pasten oder Kohlenstoff-Klebern selektiv durch zum Beispiel Drucken mit einem Sieb oder einem Tampon aufgebracht wird, wobei die Schicht anschließend zu ihrer Formierung bei einer Temperatur T mit T<200°C, vorzugsweise 140°C<T<160°C, thermisch behandlet wird.

13. Verfahren nach Anspruch 10, dadurch gekennzeichnet, daß die auf die zweite Halbleiterschicht aufgetragene ALS Maske dienende Fixierschicht ein aktivierbarer Kleber ist und zum Beispiel durch Temperatur-, Druck-, oder UV-Strahlen- oder IR-Strahlen-Einwirkung ausgehärtet wird.

14. Verfahren nach Anspruch 13, dadurch gekennzeichnet, daß die als Maske wirkende Fixierschicht wahlweise vor oder nach Auftragen der Kontaktvermittlerschicht auf die zweite Halbleiterscicht in die in der Kontaktvermittlerschicht vorhandenen Freiräume aufgetragen wird.

15. Verfahren nach Anspruch 11 mit ITO, $SnO_x$ oder $CdSnO_x$ als Kontaktvermittlerschicht, dadurch gekennzeichnet, daß unmittelbar nach Auftragen der Kontaktvermittlerschicht die Fixierschicht für die weiteren Schichten des zweiten elektrisch leitenden Kontaktes selektiv aufgetragen wird.

**Revendications**

1. Cellule photovoltaïque, en particulier cellule solaire en couche mince (10, 50) comprenant un premier contact électrique (14) appliqué sur un support (12) sur lequel sont disposées une première (arrière) et une deuxième (frontale) couche semiconductrice (16, 18) de types de conductivité différents, un second contact électrique (frontal) comprenant trois couches (22, 24, 26) relié à la deuxième couche semi-conductrice (18) ainsi que, le cas échéant, un élément de couverture (34) tel qu'une lamelle recouvrant la cellule, caractérisé en ce que les trois couches (22, 24, 26) du contact frontal (20, 52) se composent d'une couche intermédiaire de contact (22) formant un couplage ohmique vers la seconde couche semi-conductrice (18), constituée d'ITO, $SnO_x$, $Cd\ SnO_x$, d'un conducteur organique, d'or, de palladium, d'une pâte de carbone, ou d'une colle carbonée et présentant une résistance spécifique $S{\leq}1$ ohm/$cm^2$, d'une couche de collection du courant (24) collectant les porteurs de charge de la deuxième couche semi-conductrice et ayant une résistance spécifique $S{\leq}10^{-2}$ ohm/$cm^2$ et d'une couche de dérivation (26) ayant une résistance spécifique $S{\leq}10^{-4}$ ohm/$cm^2$ chacune des trois couches ne recouvrant la deuxième couche semi-conductrice (18) que d'une manière sectorielle et au moins deux couches n'étant pas alignées en vue de dessus.

2. Cellule selon la revendication 1, caractérisée en ce que la couche de collection (24) et la couche de dérivation (26) sont incluses au moins partiellement dans une couche (30) on sont collés une telle couche (30) en particulier pour leur fixation.

3. Cellule selon la revendication 2, caractérisée en ce que la couche de fixation (30) constitue un masque pour l'application des couches formant le contact électrique frontal ou de quelques-unes d'entre elles.

4. Cellule selon la revendication 1, caractérisée en ce que la couche de collection du courant (24) et la couche de dérivation (26) sont appliquées d'une manière sélective dans leur ensemble et consistent de préférence en des lignes ou des traits qui se croisent.

5. Cellule selon la revendication 1, caractérisée en ce que la couche intermédiaire de contact (22) est traitée thermiquement en vue de son formage à une température T avec T<200°C.

6. Cellule selon la revendication 1, caractérisée en ce que le couplage ohmique et la conductivité de la couche intermédiaire de contact (22) qui consiste en de la colle ou de la pâte de carbone sont déterminés par des particules de graphite et de noir de fumée.

7. Cellule selon la revendication 1, caractérisée en ce que la couche de collection de courant (24, 54) se compose d'une pâte d'argent conductrice et que la couche de dérivation de courant (26, 54) se compose d'une pâte conductrice ou d'argent, ou de cuivre.

8. Cellule selon la revendication 1, caractérisée en ce que le contact électrique frontal (20, 52) est reçu par une couche de fixation sur laquelle est appliquée une couche de desaccouplement (36) opérant un desaccouplement mécanique, la couche de fixation et la couche de desaccouplement étant composée d'un même matériau de base comme par exemple du polyvinylbutyral avec des quantités différentes de plastifiants.

9. Procédé d'obtention de cellules photovoltaïques selon l'une des revendications 1 à 8, comprenant essentiellement les étapes de procédé suivantes:

a) application d'un premier contact électriquement conducteur sur un support,

b) application d'une première couche semi-conductrice frontale puis d'une deuxième de type de conductivité différente, sur le premier contact électriquement conducteur,

c) application d'un deuxième contact électriquement conducteur (frontal) sur la deuxième couche semi-conductrice,

d) recouvrement du deuxième contact électriquement conducteur avec un élément de couverture,

e) encapsulement de la cellule photovoltaïque ou l'application du deuxième contact électriquement conducteur s'effectue par l'application successive des différentes couches électriquement conductrices, chaque deuxième couche semi-conductrice n'étant recouverte que par zones et au moins deux de ces couches n'étant pas alignées l'une par rapport à l'autre, une couche de desaccouplement mécanique de l'élément de couverture du second contact électriquement conducteur étant appliquée sur ce dernier.

10. Procédé selon la revendication 9, caractérisé en ce qu'au moins une des couches supérieures situées du côté de la source de lumière du deuxième contact électriquement conducteur est fixée à partie d'une couche de fixation.

11. Procédé selon la revendication 10, caractérisé en ce que la couche de fixation, préférentiellement appliquée par un procédé du type sérigraphie, est constituée par une couche de masquage possédant des espaces libres dans lesquels sont mises en place au moins certaines des couches formant le deuxième contact électriquement conducteur.

12. Procédé selon la revendication 9, caractérisé en ce que la couche intermédiaire de contact à base de pâtes ou de colles carbonées est appliquée, d'une manière sélective, par exemple par impressions avec un tissu métallique ou un tampon, consécutivement à son formage, cette couche étant traitée thermiquement à une température T, avec T<200°C, de préférence 140°C<T<160°C.

13. Procédé selon la revendication 10, caractérisé en ce que la couche de fixation servant de masque, qui est appliquée sur la deuxième couche semi-conductrice, est constituée par une colle pouvant être activée, et est soumise à une cuisson par exemple sous l'action de la température, la pression, ou un rayonnement UV ou encore un rayonnement IR.

14. Procédé selon la revendication 13, caractérisé en ce que la couche de fixation servant de masque est appliquée, sur la deuxième couche semi-conductrice dans les espaces libres présents dans la couche intermédiaire de contact, à volonté avant ou après l'application de la couche intermédiaire de contact.

15. Procédé selon la revendication 11, avec comme couche intermédiaire de contact ITO, SnO$_x$ ou Cd SnO$_x$, caractérisé en ce qu'immédiatement après l'application de la couche intermédiaire de contact, la couche de fixation des autres couches du deuxième contact électriquement conducteur est appliquée d'une manière sélective.

## Claims

1. Photovoltaic cell, especially a thin-layer solar cell (10, 50) comprising a (first) electric contact (14) deposited on a carrier (12), on which contact being arranged a first (rear surface) and a second (front surface) semiconductor layer (16, 18) of different type of conductor, a second (front surface) electric contact connected to the second semiconductor layer (18), said second electric contact comprising three layers (22, 24, 26), as well as possibly a covering element (34) covering the cell like a cover glass, characterized in that the three layers (22, 24, 26) of the front surface contact (20, 52) are composed of a contact transmitting layer (22) forming an ohmic coupling to the second semiconductor layer (18), said contact transmitting layer consisting of ITO, SnO$_x$, CdSnO$_x$, an organic conductor, gold, palladium, carbon paste or carbon glue and having a specific resistivity of $\rho \leq 1$ ohm cm, a current collecting layer (24) collecting charge carriers of the second semiconductor layer with a specific resistivity of $\rho \leq 10^{-2}$ ohm cm, and a current discharging layer (26) with a specific resistivity of $\rho \leq 10^{-4}$ ohm cm, where each of the three layers covers only sectionally the second semiconductor layer (18) and where, in top view, at least two layers are not arranged in alignment to each other.

2. Cell according to claim 1, characterized in that the current collecting layer (24) and the current discharging layer (26), especially for the fixation of the same, are embedded at least partially in a layer (30) or are glued together with this layer (30).

3. Cell according to claim 2, characterized in that the fixation layer (30) is used as a mask for the application of the layers or some of them constituting the front surface electric contact.

4. Cell according to claim 1, characterized in that the current collecting layer (24) and the current discharging layer (26) as an unit are deposited selectively and consist of lines resp. stripes crossing each other.

5. Cell according to claim 1, characterized in that the contact transmitting layer (22) for its shaping is thermally treated at a temperature T with T<200°C.

6. Cell according to claim 1, characterized in that the ohmic coupling and the conductivity of the contact transmitting layer (22, 54) are defined by graphite and soot particles.

7. Cell according to claim 1, characterized in that the current collecting layer (24, 54) consists of a silver conducting paste, and that the current discharging layer (26, 54) consists of copper or silver conducting paste.

8. Cell according to claim 1, characterized in that the front surface electric contact (20, 52) is accommodated by a fixation layer to which a discoupling layer (36) is applied effecting a mechanic discoupling, where the fixation layer and the discoupling layer are made of the same basic material like, for example, polyvinyl butyral with different percentages of softeners.

9. Method for the manufacture of photovoltaic cells according to one of the claims 1 to 8, essentially comrising the following method steps:

a) deposition of a first electrically conducting contact on a carrier,

b) deposition of a first and subsequently a second front surface semiconductor layer of different type of conductor on the first electrically conducting contact,

c) deposition of a second (front surface) electrically conducting contact on the second semiconductor layer,

d) covering of the second electrically conducting contact with a cover element,

e) encapsulation of the photovoltaic cell,

where the deposition of the second electrically conducting contact is effected by successive application of the different electrically conducting layers, each of which covers only sectionally the second semiconductor layer and two of which, at least, are not arranged in alignment to each other, and where on the second electrically conducting contact a layer is deposited which mechanically discouples the cover element from said second contact.

10. Method according to claim 9, characterized in that at least one of the upper layers of the second electrically conducting contact facing the light source is fixed by a fixation layer.

11. Method according to claim 10, characterized in that the fixation layer preferably being applied after the screen printing process is formed like a masking layer provided with free spaces in which, at least, some of the layers forming the second electrically conducting contact can be imbedded.

12. Method according to claim 9, characterized in that the contact transmitting layer made of carbon pastes or carbon glues is selectively applied by, for example, printing with a screen or a tampon, where the layer for its shaping is subsequently thermally treated at a temperature T with T<200°C, preferably 140°C<T<160°C.

13. Method according to claim 10, characterized in that the fixation layer being deposited on the second semiconductor layer as a mask is an activatable glue which is cure for example, by the influence of temperature, pressure, ultra-violet rays or IR-rays.

14. Method according to claim 13, characterized in that the fixation layer having a masking effect is deposited in the free spaces in the contact transmitting layer at option either prior to or after the application of the contact transmitting layer on the second semiconductor layer.

15. Method according to claim 11 with ITO, $SnO_x$ or $CdSnO_x$ as contact transmitting layer, characterized in that immediately after application of the contact transmitting layer, the fixation layer for the additional layers of the second electrically conducting contact is selectively deposited.

34

10

32

36

30

26

26

28

28

20

24

24

22

18

16

14

12

<u>FIG.1</u>

50

38

48

42

44

56

52

46

40

58

54

<u>FIG.2</u>

<u>FIG.3</u>